Europäisches Patentamt

European Patent Office

Office européen des brevets

(19)

(11) Numéro de publication : **0 242 295 B1**

(12) **FASCICULE DE BREVET EUROPEEN**

(45) Date de publication du fascicule du brevet :
**13.03.91 Bulletin 91/11**

(51) Int. Cl.⁵ : **H01L 23/00, G21F 1/10,
G21F 1/12**

(21) Numéro de dépôt : **87400850.1**

(22) Date de dépôt : **14.04.87**

(54) **Boîtier de protection de circuits électroniques, durci vis-à-vis des rayons X.**

(30) Priorité : **16.04.86 FR 8605442**

(43) Date de publication de la demande :
**21.10.87 Bulletin 87/43**

(45) Mention de la délivrance du brevet :
**13.03.91 Bulletin 91/11**

(84) Etats contractants désignés :
**BE CH DE ES GB IT LI NL SE**

(56) Documents cités :
**EP-A- 0 128 079
FR-A- 2 406 870
US-A- 2 929 948
US-A- 3 622 432
PATENT ABSTRACTS OF JAPAN, vol. 9, no.
295 (E-360)[2018], 21 novembre 1985; & JP-
A-60 134 448
PATENT ABSTRACTS OF JAPAN, vol. 10, no.
27 (E-378)[2084], 4 février 1986; & JP-A-60 186
040**

(73) Titulaire : **AEROSPATIALE Société Nationale
Industrielle
37, Boulevard de Montmorency
F-75781 Paris Cédex 16 (FR)**

(72) Inventeur : **Valy, Yves
41, rue Edouard Branly
F-33160 Saint Médard en Jalles (FR)**
Inventeur : **Gadbin, Michel
16, rue Verly
F-33700 Mérignac (FR)**
Inventeur : **Sainte Luce Banchelin, Jean
15, rue de l'Aste
F-33160 Saint Médard en Jalles (FR)**
Inventeur : **Bourcereau, Jean
62, rue Berruer
F-33000 Bordeaux (FR)**

(74) Mandataire : **Mongrédien, André et al
c/o SOCIETE DE PROTECTION DES
INVENTIONS 25, rue de Ponthieu
F-75008 Paris (FR)**

EP 0 242 295 B1

## Description

La présente invention a pour objet un boîtier de protection de circuits électroniques, durci vis-à-vis des rayons X. Elle s'applique plus spécialement à la protection contre les rayons X des circuits électroniques performants employés dans les domaines aéronautique et spatial.

Les circuits électroniques performants, tant sur le plan de la vitesse de traitement que de la capacité, sont très sensibles aux effets des rayons X ; ces effets peuvent aller jusqu'à la destruction des composants actifs des circuits électroniques en passant par des phénomènes de parasitage et de blocage (phénomène de latch up en terminologie anglo-saxonne).

En plus de la quantité ou dose de rayonnements X reçue, un paramètre particulièrement important est celui de la durée pendant laquelle cette quantité est délivrée ; la dose associée à sa durée d'application est appelée le débit de dose. La tenue des composants actifs des circuits électroniques à ces paramètres (dose, débit de dose) et au spectre d'énergie de ce rayonnements est essentiellement liée à leur technologie de fabrication. Dans la plupart des cas, il est nécessaire de réduire les niveaux de dose et de débits de dose pour permettre aux circuits électroniques de garder leur intégrité fonctionnelle.

L'une des techniques les plus utilisées pour réduire les doses et débits de dose reçus par les circuits électroniques consiste à enfermer ces circuits dans une enveloppe de métal pur de numéro atomique élevé. Le métal et l'épaisseur de la feuille métallique sont choisis et adaptés en fonction de l'énergie du rayonnement X considéré et du taux de filtrage désiré. Cette feuille de métal tend à assurer une protection efficace contre les doses et débits de dose élevés de rayons X. Suivant les circuits et/ou la technologie des composants électroniques le besoin de protection peut se faire sentir partir de 10 à 300 Sv (1 à 10 krad) et de $10^3$ à $10^5$ Sv.s ($10^5$ $10^7$ rad.s).

En général, la feuille métallique recouvre une structure en métal, notamment en alliage léger, renfermant les circuits électroniques, cette structure assurant la fonction de résistance et protection mécaniques. La feuille de métal est fixée sur toute la surface externe de la structure métallique de façon mécanique.

Malheureusement, la mise en oeuvre des métaux les plus intéressants pour ce type de protection est difficile et coûteuse. Par ailleurs, les exigences vis-à-vis de ces matériaux de protection et la garantie de leur non dégradation vis-à-vis des diverses ambiances, climatiques, mécaniques, ionisantes, font que le devis de masse de l'ensemble des circuits électroniques est fortement augmenté par rapport aux circuits non protégés contre les rayons X.

Dans la plupart des cas, la feuille métallique de protection contre les rayons X ne peut être placée directement sur la totalité des faces extérieures de la structure métallique du boîtier d'encapsulation à cause du profil souvent complexe de celle-ci. Cette complexité de profil est souvent imposée par des contraintes de dissipation thermique.

En conséquence, le volume défini par la feuille de protection métallique se trouve être supérieur au volume de la structure mécanique à protéger. Ceci conduit à une augmentation du poids et de l'encombrement de la structure mécanique, augmentation renforcée par des dispositifs mécaniques qui deviennent nécessaires pour le maintien en place de la feuille métallique sur la structure mécanique (entretoises, équerres, visserie, etc...). En outre, ces dispositifs de maintien doivent être réalisés dans le même métal que celui de la feuille métallique de protection afin de ne pas créer de "trous" dans la protection contre les rayons X.

Par ailleurs, le fait de réaliser la structure mécanique en métal ou en alliage augmente encore le poids total du boîtier d'encapsulation des circuits électroniques.

On conçoit que ces inconvénients d'encombrement et de poids des boîtiers d'encapsulation sont particulièrement gênants au niveau de l'emploi des circuits électroniques embarqués sur aéronef.

Une autre technique consiste à effectuer directement le dépôt de métal de protection contre les rayons X sur la structure mécanique à protéger soit par trempage de celle-ci dans un bain liquide, soit par électrolyse. Malheureusement, ces procédés de dépôt ne sont pas possibles pour tous les métaux utilisables pour la protection contre les rayons X. De plus, il y a toujours lieu dans cette méthode d'examiner les compatibilités de corrosion des métaux en présence.

D'autre part, les épaisseurs pouvant être déposées pour les métaux se prêtant à cette technique sont limitées, sauf à mettre en cause la qualité d'adhérence du dépôt. De plus, l'obtention de dépôt homogène impose de procéder par étapes successives avec reprise d'usinage entre les dépôts afin d'assurer, dans certains cas, le respect des cotes du boîtier d'encapsulation au stade final. Ces techniques de dépôt sont donc limitées et entraînent un coût élevé des boîtiers d'encapsulation protégés contre les rayons X.

Une autre approche consiste à envisager une protection spécifique pour chaque composant électronique embarqué, ceci constitue une solution différente et évoluée par rapport aux solutions classiques précédentes. Cette protection spécifique, décrite dans le document FR-A-2 547 113 déposé le 3 juin 1983, consiste à utiliser plusieurs couches empilées de matériaux différents ayant des numéros atomiques (Z) distincts.

Comme matériau ayant un nombre de charge atomique élevé, il est cité des céramiques diélectriques telles que le titanate de baryum ou de néodyme, l'oxyde de titane ou encore une céramique complexe à base de plomb.

Comme matériau ayant un nombre de charge atomique faible, il est cité le carbone, l'aluminium, le silicium, l'alumine et la silice.

Suivant les applications et le nombre de composants concernés, la multiplication des protections individuelles peut se révéler plus pénalisante en poids qu'une protection globale de l'ensemble des composants électroniques. Par ailleurs, la technologie d'élaboration des divers matériaux constituant les empilements s'appuie sur des procédés utilisés pour la fabrication de condensateurs et notamment de procédés de frittage. En particulier, le procédé décrit ne permet pas l'obtention d'un matériau de protection contre les rayons X ayant une forme complexe.

Dans le cadre de la protection de personnes travaillant en présence de rayons X, les matériaux utilisés se composent principalement d'une charge telle que le plomb, dispersée dans un liant organique. De tels matériaux de protection sont en particulier décrits dans le document FR-A-2 190 717 déposé au nom de la Société Giken, le document FR-A-2 482 761 déposé au nom de A. Maurin, et le brevet US-A-3 622 432 de la H.K. PORTER Company.

Ces matériaux à base de plomb ne peuvent être utilisés comme matériau de protection contre les rayons X que pour des rayonnements de faible débit de dose associé à des temps de distribution de la dose relativement importants.

Comme autre boîtier connu d'encapsulation de circuits électroniques, on peut citer celui décrit dans le document FR-A-2 490 917 déposé le 2 septembre 1980. Ce boîtier est constitué d'une matière plastique moulée telle qu'une résine époxyde dans laquelle sont noyés les circuits électroniques. Ce boîtier est extrêmement mince et ne permet pas d'assurer une protection mécanique efficace des circuits électroniques. Par ailleurs, aucune protection contre les rayons X n'est prévue.

La présente invention a justement pour objet un boîtier de protection de circuits électroniques, durci vis-à-vis des rayons X, permettant de remédier aux différents inconvénients donnés ci-dessus. En particulier, ce boîtier de protection permet, par rapport à l'emploi d'une feuille de métal lourd recouvrant une structure métallique, un gain de masse et d'encombrement important tout en assurant une protection efficace contre les rayonnements de fort débit de dose et en particulier supérieurs à ceux cités plus avant.

Par ailleurs, ce boîtier de protection ne pose pas de problème majeur de fabrication : il peut être réalisé en un temps beaucoup plus court que celui nécessaire pour la fabrication des boîtiers d'encapsulation de l'art antérieur.

En outre, l'invention permet, par rapport au document FR-A-2 547 113 cité ci-dessus, une évolution des niveaux de protection X sans incidence sur la définition des circuits électroniques contenus dans le boîtier.

De façon plus précise, l'invention a pour objet un boîtier de protection de circuits électroniques, durci vis-à-vis des rayons X, caractérisé en ce qu'il comprend au moins un élément formé d'une structure mécanique rigide en matériau composite, constitué d'une résine renforcée par des fibres, et d'un matériau de protection contre les rayons X recouvrant au moins en partie la structure mécanique, ce matériau de protection X étant formé d'une matrice en résine renfermant, sous forme d'une poudre régulièrement dispersée, au moins un métal et/ou au moins un composé inorganique d'un métal, la poudre ne fondant qu'à une température au moins égale à 630°C et le métal présentant un numéro atomique élevé, au moins égal à 47.

En particulier, la poudre peut être constituée d'un métal et d'un composé inorganique de ce même métal ou d'un autre métal. Ce métal et ce composé inorganique présente une température de fusion supérieure ou égale à 630°C.

Par élément du boîtier, il faut comprendre toute partie entrant dans la constitution du boîtier, telle que le capot, ou l'embase sur lequel est fixé le capot, ainsi qu'une partie du capot ou de l'embase (cas d'un capot ou d'une embase en plusieurs morceaux).

La protection X doit être associée à la totalité des faces apparentes du boîtier, compte tenu du sens aléatoire des rayonnements X.

L'utilisation de matériaux de température de fusion élevée permet d'éviter les effets indésirables dus aux chocs thermiques provoqués au sein du matériau lors d'une irradiation X, effets tels que la fusion superficielle des grains de la poudre pouvant conduire à la destruction du matériau de protection. En outre, l'utilisation d'un métal de numéro atomique élevé, supérieur ou égal à 47, permet un filtrage efficace des rayons X.

A quantité de matériau égale, l'utilisation d'une poudre répartie régulièrement dans une matrice en résine amène une perte d'efficacité par rapport au métal pur en feuille, toutes autres conditions identiques par ailleurs. Cette perte d'efficacité étant fonction essentiellement de la granulométrie de la poudre et de la quantité de poudre dans le liant organique, on choisit de préférence une poudre présentant une granulométrie allant de 0,5 à 25 µm, et par exemple allant de 1,6 à 10 µm.

De même, la quantité de poudre dans le liant peut aller de 25 à 50% en volume du matériau fini de protection contre les rayons X. La quantité de dopage du liant organique dans cette gamme est fonction de l'efficacité recherchée pour la protection X. Il en est de même pour l'épaisseur du matériau de protection contre les rayons X.

La résine utilisée pour former la matrice du matériau de protection peut être une résine thermoplastique ou thermodurcissable dont le coefficient de dilatation thermique est compatible avec celui du matériau composite formant la structure mécanique et dont le catalyseur de polymérisation est compatible avec la résine dudit matériau composite.

Comme résine entrant dans la composition du matériau de protection X, on peut par exemple citer les polyamides, les polyéthers, les polyesters, les phénoplastes, les polyoléfines, les époxydes, les polyimides, les silicones, les furaniques, etc.

La poudre métallique noyée dans la matrice organique du matériau de protection X peut être une poudre d'argent, d'antimoine, de baryum, d'une terre rare, de tantale, de tungstène, de rhénium, d'iridium, de platine, d'or, d'uranium, d'hafnium ou un mélange de ces métaux. On utilise de préférence l'argent, le tantale, le tungstène ou l'uranium.

Lorsque la poudre est constituée d'un composant inorganique, celle-ci peut être un oxyde, un nitrure ou un carbure d'un métal lourd tels que ceux cités ci-dessus. En particulier, le composé inorganique est un oxyde, un nitrure, ou un carbure d'argent, de tantale, de tungstène ou d'uranium lorsque ce composé existe effectivement.

Afin d'optimiser la protection contre les rayons X sur un spectre d'énergie très étendue, on peut utiliser un ou plusieurs métaux et/ou un ou plusieurs composés inorganiques d'un métal.

La structure mécanique rigide est constituée en un matériau permettant de supporter les contraintes mécaniques auxquelles le boîtier de protection final doit satisfaire. Elle peut être formée à partir d'une résine thermoplastique ou thermodurcissable renforcée par des fibres.

Toutefois, afin d'assurer une excellente résistance mécanique, on utilise de préférence des résines thermodurcissables telles que des résines époxydes, phénoliques, polyesters, polyimides, furaniques. Les fibres de renfort peuvent être courtes ou longues et être réalisées en un matériau organique ou inorganique tel que le verre, le carbone, le bore, le kevlar ou en métal.

Ce matériau composite (résine + fibres) présente une densité allant de 1,2 à 1,8 au lieu de 2,8 pour l'aluminium. Le gain en poids d'une structure rigide selon l'invention est donc important.

La structure mécanique présente une forme et un dimensionnement correspondant aux besoins de fixation et d'aménagement des circuits électroniques devant y être logés. Elle est obtenue par moulage soit par injection, soit par compression ou soit par une technique hybride dite "moulage par compression-transfert" décrite dans la demande de brevet français n° 85 18769 déposée le 18 décembre 1985 au nom du demandeur.

Sur la structure rigide ainsi obtenue, on effectue un surmoulage du matériau de protection contre les rayons X soit par injection, soit par compression. Afin d'assurer une bonne adhérence du matériau de protection X sur la structure mécanique, cette dernière peut être préalablement chauffée et/ou faire l'objet d'une préparation de surface.

Afin d'obtenir une bonne répartition de la poudre dans le liant organique, formant le matériau de protection contre les rayons X, gage d'une homogénéité de l'opacité, on effectue avant le surmoulage un prémélange de la poudre et du liant.

Ce prémélange est effectué soit en mélangeant la poudre à des grains fondus de la résine puis en formant des granulés de mélange par extrusion, soit par simple mélange de poudres, soit par mélange de la poudre dans un liant organique liquide. Ce prémélange est ensuite introduit dans le moule pour être polymérisé sur la structure mécanique.

La réalisation du matériau de protection X par surmoulage permet d'assurer une adhérence continue et homogène du matériau sur la structure mécanique rigide. Ceci permet notamment de réduire l'encombrement global du boîtier d'encapsulation par rapport aux solutions de l'art antérieur.

Afin d'améliorer l'accrochage du matériau de protection contre les rayons X sur la structure rigide mécanique, celle-ci peut être munie d'encoches, formées lors du moulage de la structure. Ces encoches se remplissent du matériau de protection contre les rayons X lors du surmoulage de ce dernier, assurant ainsi un effet d'accrochage supplémentaire recherché.

Afin d'éviter l'émission d'électrons par les parois ou éléments du boîtier de protection lors d'une irradiation X et en particulier par la poudre métallique, l'élément de boîtier peut être recouvert d'un matériau formé d'au moins un élément de numéro atomique faible, au plus égal à 6, constituant au moins en partie la surface externe ou interne dudit élément de boîtier.

Ce matériau présente une épaisseur supérieure au libre parcours moyen des électrons émis par les parois du boîtier protégées contre les rayons X, lors de l'irradiation X. Il constitue toujours un revêtement de dernière couche vers l'atmosphère environnante.

Comme élément de numéro atomique faible on peut citer le carbone, le bore, et le béryllium.

Le matériau servant empêcher ces effets d'émissivité des parois du boîtier de protection est généralement connu sous le nom de matériau anti-SGEMP (System Generating Electro Magnetic Pulse en terminologie anglo-saxonne). Il peut se présenter sous la forme d'une peinture renfermant des particules de l'élément de numéro atomique au plus égale à 6. La peinture est par exemple de type Pyroflex 7D 713 d'Astral.

De façon avantageuse, l'élément considéré du boîtier de protection est équipé d'un matériau bon conducteur de l'électricité servant à filtrer les ondes électromagnétiques autres que les rayons X, ce matériau recouvre soit la surface externe de l'ensemble formé par la structure mécanique et le matériau de protection X et/ou la surface interne de la structure mécanique.

Ce matériau bon conducteur de l'électricité constitue une cage de Faraday protégeant les circuits électroniques logés dans le boîtier de protection. Il sera dénommé ci-après matériau de "faradisation".

Comme matériau de "faradisation" on peut citer le nickel, l'argent, l'aluminium pur, le cuivre et le béryllium.

Le béryllium a l'avantage de pouvoir jouer à la fois le rôle de matériau anti-SGEMP et le rôle de cage de Faraday, compte tenu de son faible numéro atomique et de sa bonne conductivité électrique.

D'autres caractéristiques et avantages de l'invention ressortiront mieux de la description qui va suivre donnée à titre illustratif et non limitatif, en référence aux figures annexées, dans lesquelles :

    – la figure 1 représente schématiquement, en coupe longitudinale, un premier mode de réalisation du dispositif de protection selon l'invention,

    – la figure 2 représente schématiquement, en coupe longitudinale, un second mode de réalisation du boîtier de protection selon l'invention, et

    – la figure 3 représente schématiquement, en coupe longitudinale, un troisième mode de réalisation du boîtier de protection selon l'invention.

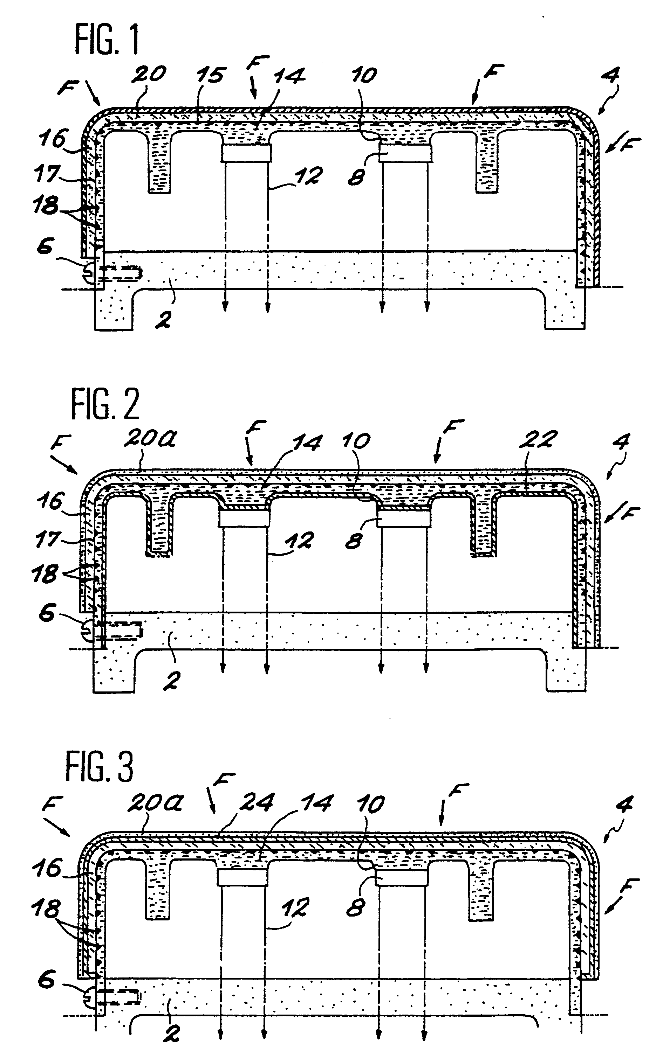

En vue d'une simplification de la description, celle-ci se réfère à un boîtier de protection, formé d'un capot monobloc fixé sur une embase en une seule partie, dans lequel l'élément susceptible d'être irradié par un rayonnement X est le boîtier ; les possibilités de direction du sens du flux d'irradiation X sont représentées par les flèches F sur les figures 1-3. Bien entendu, comme donné précédemment, l'invention est d'application beaucoup plus générale.

Sur la figure 1, on a schématisé en coupe longitudinale un boîtier de protection de circuits électroniques comportant une embase 2 sur laquelle vient se fixer un capot 4 par exemple à l'aide de vis 6. Ce boîtier est prévu pour recevoir les circuits électroniques 8. En particulier, ces circuits peuvent être fixés par tout moyen connu sur des bossages 10 prévus à cet effet sur la face interne du capot 4 du boîtier. De manière très schématique, n'étant pas l'objet de la présente demande de brevet, les circuits électroniques 8 sont connectés à des circuits électriques, extérieurs au boîtier, par des pistes conductrices schématisées en 12 et traversant par exemple l'embase 2 du boîtier.

La forme spécifique du boîtier, ainsi que la fixation et la connexion des circuits électroniques, logés dans le boîtier de protection contre les rayonnements X, sont liées au type de composants utilisés. Lesdits composants peuvent être encapsulés dans des boîtiers TO 5, TO 66, etc...

Selon l'invention, le capot 4 comporte une structure rigide 14 assurant la protection mécanique des circuits électroniques. Cette structure 14 est formée d'une matière plastique thermodurcissable telle que la bakélite, les résines polyimides ou les silicones, renforcée par des fibres organiques ou non. Cette structure 14 est par exemple réalisée en KINEL 5504 commercialisée par la Société Rhône Poulenc, ce matériau étant une résine polyimide renforcée par des fibres de verre longues, disposées de manière aléatoire. Cette structure rigide 14 est formée par moulage, soit par injection, soit par compression, techniques bien connues de l'homme du métier. Elle peut présenter une épaisseur de 2 mm.

La protection contre les rayons X des circuits électroniques 8 logés dans le boîtier est assurée à l'aide d'un matériau en couche 16 en contact avec la surface interne de la structure rigide 14 ou, comme représenté sur la figure, en contact avec la surface externe de la structure rigide.

Le matériau 16 de protection X recouvre toute la partie de la surface externe de la structure 14 susceptible d'être irradiée par des rayonnements X. Dans le cas représenté sur la figure 1, la couche de matériau 16 recouvre donc toute la surface externe de la structure 14, soit la face supérieure 15 et les faces latérales 17 de cette structure.

Afin d'assurer une bonne adhérence du matériau de protection 16 sur la structure rigide 14, cette dernière peut être équipée d'encoches 18, formées lors du moulage de la structure rigide 14. Ces encoches 18 sont remplies de matériau de protection X lors du surmoulage de ce dernier.

Le matériau 16 de protection X est par exemple formé d'une poudre de tungstène représentant 30% en volume du produit fini, régulièrement dispersée, dans une résine PA11 de chez ATOCHEM. Cette résine est une résine polyamide thermoplastique. La poudre de tungstène présente une granulométrie moyenne de 4 μm et une dispersion de 2,5. Sa pureté est de 99,9%.

Ce matériau de protection peut être obtenu par fusion de granulés de la résine PA11 auxquels on ajoute la poudre de tungstène. Le prémélange obtenu est introduit dans une extrudeuse-granuleuse ZSK30 de la Société Werner afin d'obtenir des granulés de mélange qui peuvent être ensuite introduits dans un moule contenant déjà la structure rigide 14 à recouvrir par le matériau de protection X. L'introduction des granulés de mélange dans le moule se fait par injection. Le surmoulage du matériau de protection X est assuré sur la structure rigide 14 chauffée afin de faciliter l'adhérence du matériau X. Le matériau de protection obtenu peut présenter une épaisseur de 1,5 mm.

Le moulage et le surmoulage respectivement de la structure rigide 14 et du matériau 16 de protection X permettent d'obtenir directement des capots de boîtiers de protection aux dimensions et précisions souhaitées sans reprise d'usinage. Par ailleurs, ces techniques de moulage sont particulièrement avantageuses du point de vue financier et temps de fabrication dès lors que les séries de capots de boîtiers à réaliser permettent d'amortir les prix des outillages spécifiques de chaque modèle de boîtier.

Le matériau de protection X peut aussi être constitué d'une poudre contenant 6% en volume de tungstène et 24% en volume d'oxyde d'uranium ($UO_2$) noyé dans la résine PA11. Ce matériau peut présenter une épaisseur de 2 mm afin d'assurer un filtrage efficace.

De même, la résine polyamide PA11 peut être remplacée par une résine polyétherblockamide. Une telle résine est commercialisée sous le nom de DINYL de chez Rhône-Poulenc. La résine du matériau de protection 16 peut encore être en bakélite ou en silicone.

Afin d'éviter le renforcement du niveau électromagnétique dû à l'émission d'électrons par les parois extérieures du boîtier de protection, lors d'une irradiation X, et en particulier par le métal contenu dans le matériau 16 de protection X, un matériau 20 anti-SGEMP formant la surface externe du capot 4 peut être prévu. Dans le cas représenté sur la figure 1, ce matériau 20 recouvre totalement le matériau 16 de protection X. Il est réalisé en béryllium assurant ainsi en plus de la fonction anti-SGEMP, la protection des circuits électroniques 8 contre les ondes électromagnétiques.

La fermeture de la cage de Faraday est obtenue, pour le cas décrit ici, par la présence de l'embase 2 réalisée ou recouverte en un métal bon conducteur de l'électricité tel que le nickel, l'argent, l'aluminium, le béryllium ou le cuivre.

Ce matériau 20 doit présenter une épaisseur supérieure au libre parcours moyen des électrons émis par les parois du capot. Il constitue en outre un revêtement de dernière couche. En particulier, dans le cas d'un matériau de protection X recouvrant la surface interne de la structure mécanique, le matériau anti-SGEMP constitue avantageusement la surface interne du capot.

Il est possible d'envisager l'emploi simultané d'une couche anti-SGEMP constituant la surface interne du boîtier et d'une couche anti-SGEMP constituant la surface externe du boîtier.

Sur la figure 2, on a représenté un second mode de réalisation du dispositif de protection selon l'invention. Dans ce mode de réalisation, le matériau servant à éviter les effets d'émissivité des parois du boîtier soumises aux rayons X, et en particulier du matériau 16, est réalisé en un matériau 20a mauvais conducteur de l'électricité comme le carbone ou le bore. Dans ces conditions, la protection des circuits intégrés 8 contre les ondes électromagnétiques n'est pas assurée.

Afin d'assurer cette protection, la surface interne de la structure rigide 14 est recouverte en totalité d'une couche 22 bonne conductrice de l'électricité. En particulier cette couche 22 est réalisée en un métal tel que le nickel ou l'argent. Cette couche 22 présente une épaisseur d'environ 0,1 mm. Les autres parties du boîtier de protection et en particulier du capot 4 sont inchangées par rapport au cas de la figure 1.

Sur la figure 3, on a représenté un troisième mode de réalisation du boîtier de protection selon l'invention. Ce mode de réalisation ne diffère de celui de la figure 2 que par le fait que la couche jouant le rôle de cage de Faraday est disposée entre la couche de matériau anti-SGEMP 20a et la couche de matériau 16 de protection X. Cette couche 24 présente une épaisseur de 0,1 mm et est réalisée notamment en argent ou en nickel.

Comme dans le cas de la figure 1, la cage de Faraday est fermée par la présence de l'embase 2 réalisée en métal ou recouverte d'un métal de bonne conductivité électrique.

En vue de simplifier la fabrication du boîtier de protection selon l'invention et d'assurer une bonne isolation des circuits électroniques 8 contre les ondes électromagnétiques, il est possible de prévoir une couche de "faradisation" 22-24 recouvrant à la fois la face interne de la structure mécanique 14 (figure 2) et la surface externe du matériau de protection 16 contre les rayons X (figure 3). Ceci peut être réalisé par simple trempage de la structure mécanique 14, revêtue du matériau de protection 16, dans un bain contenant le métal à déposer pour jouer le rôle de cage de Faraday (dépôt chimique).

Il est à noter que la couche métallique de "faradisation" ne peut pas être appliquée sur une surface en silicone compte tenu de la mauvaise adhérence, d'un tel métal sur une telle résine.

La description donnée précédemment n'a bien entendu été donnée qu'à titre illustratif, des modifications, sans pour autant sortir du cadre de l'invention, pouvant être envisagées. En particulier, le matériau de protection 16 contre les rayons X peut ne recouvrir que la face supérieure 15 de la structure mécanique ou que les faces latérales 17 de cette structure. Dans ce cas, le matériau anti-SGEMP 20 ou 20a, formant la surface externe du capot 4 du boîtier, recouvre la totalité du matériau 16 de protection X ainsi que la partie de la structure rigide 14 non recouverte par le matériau 16 de protection X. En outre, lorsque le matériau anti-SGEMP est mauvais conducteur de l'électricité, une couche de "faradisation" peut être intercalée entre la couche anti-SGEMP 20a et les parties de la surface externe de la structure 14 non recouvertes de matériau 16 de protection X.

Le dispositif de protection selon l'invention peut être utilisé partout où des circuits électroniques doivent être protégés contre les rayons X. Cette protection permet de supporter des ambiances mécaniques, climatiques sévères. En particulier, l'invention s'applique lorsqu'il est requis des conditions de masse minimum. En effet, le boîtier de protection selon l'invention permet, à efficacité de filtrage équivalente à celle d'une feuille en matériau massif recouvrant une structure mécanique métallique,un gain de masse, d'encombrement ainsi qu'une diminution des coûts de fabrication.

Ainsi, le boîtier de protection selon l'invention peut être utilisé avantageusement pour la protection de dispositifs électroniques très performants, embarqués sur aéronef.

## Revendications

1. Boîtier de protection de circuits électroniques, durci vis-à-vis des rayons X, caractérisé en ce qu'il comprend au moins un élément (4, 2) formé d'une structure mécanique rigide (14) en matériau composite, constitué par une résine renforcée par des fibres, et d'un matériau de protection (16) contre les rayons X recouvrant au moins en partie (15, 17) la structure mécanique (14), ce matériau (16) de protection X étant formé d'une matrice en résine renfermant, sous forme d'une poudre régulièrement dispersée, au moins un métal et/ou au moins un composé inorganique d'un métal, la poudre ne fondant qu'à une température au moins égale à 630°C et le métal présentant un numéro atomique élevé, au moins égal à 47.

2. Boîtier de protection selon la revendication 1, caractérisé en ce que la poudre représente 25 à 50% en volume du matériau (16) de protection X.

3. Boîtier de protection selon la revendication 1 ou 2, caractérisé en ce que le métal de numéro atomique élevé est choisi parmi l'argent, le tantale, le tungstène et l'uranium.

4. Boîtier de protection selon l'une quelconque des revendications 1 à 3, caractérisé en ce que l'élément (4) comporte un matériau (20, 20a) formé d'au moins un élément de numéro atomique faible, au plus égal à 6, constituant au moins en partie la surface externe ou interne de l'élément (4).

5. Boîtier de protection selon la revendication 4, caractérisé en ce que l'élément de numéro atomique faible est choisi parmi le carbone, le bore et le béryllium.

6. Boîtier de protection selon l'une quelconque des revendications 1 à 5, caractérisé en ce que l'élément (4) comporte un matériau (20, 24) bon conducteur de l'électricité, recouvrant la surface externe de l'ensemble (14-16) formé par la structure mécanique (14) et le matériau (16) de protection X.

7. Boîtier de protection selon l'une quelconque des revendications 1 à 5, caractérisé en ce que l'élément (4) est un capot et comporte un matériau (22) bon conducteur d'électricité recouvrant la surface interne de la structure mécanique (14).

8. Boîtier de protection selon la revendication 6 ou 7, caractérisé en ce que le matériau conducteur de l'électricité (20, 24, 22) est choisi parmi le nickel, l'argent, l'aluminium, le béryllium et le cuivre.

9. Boîtier de protection selon l'une quelconque des revendications 1 à 8, caractérisé en ce que la structure mécanique (14) comporte sur sa surface recouverte du matériau (16) de protection X des encoches (18) servant à améliorer l'adhérence dudit matériau de protection sur ladite structure mécanique.

10. Boîtier de protection selon l'une quelconque des revendications 1 à 9, caractérisé en ce que le matériau composite constituant la structure mécanique (14) est formée d'une résine thermodurcissable.

11. Boîtier de protection selon l'une quelconque des revendications 1 à 10, caractérisé en ce que la structure mécanique (14) est obtenue par moulage et le matériau (16) de protection X est obtenu par surmoulage de la structure mécanique (14).

## Ansprüche

1. Schutzgehäuse für elektronische Schaltkreise, das gegen Röntgenstrahlen abgeschirmt ist, dadurch gekennzeichnet, daß es wenigstens ein Element (4, 2) umfaßt, daß in einer mechanischen, steifen Struktur (14) aus einem zusammen gesetzten Material, das aus faserverstärktem Harz besteht, und einem Schutzmaterial (16) gegen die Röntgenstrahlen geformt ist, das wenigstens teilweise (15, 17) die mechanische Struktur (14) bedeckt, wobei dieses Röngenschutzmaterial (16) aus einer Harzmatrix besteht, die in der Form eines regelmäßig verteilten Pulvers wenigstens ein Metall und/oder eine anorganische Metallverbindung einschließt, wobei das Pulver erst ab einer Temperatur von wenigstens 630°C schmilzt und das Metall eine erhöhte atomare Ordnungszahl von wenigstens 47 besitzt.

2. Schutzgehäuse nach Anspruch 1, dadurch gekennzeichnet, daß das Pulver 25-50 Volumenprozent des Röntgenschutzmaterials (16) bildet.

3. Schutzgehäuse nach Anspruch 1 oder 2, dadurch gekennzeichnet, daß das Metall mit erhöhter atomarer Ordnungszahl unter dem Silber, dem Tantal, dem Wolfram und dem Uran ausgewählt wird.

4. Schutzgehäuse nach einem der Ansprüche 1 bis 3, dadurch gekennzeichnet, daß das Element (4) ein Material (20, 20a) umfaßt, das aus wenigstens einem Element mit geringer atomarer Ordnungszahl, höchstens 6, gebildet ist, das wenigstens teilweise die äußere oder innere Oberfläche des Elements (4) bildet.

5. Schutzgehäuse nach Anspruch 4, dadurch gekennzeichnet, daß das Element mit geringer atomarer Ordnungszahl unter dem Kohlenstoff, dem Bor und dem Beryllium ausgewählt wird.

6. Schutzgehäuse nach einem der Ansprüche 1 bis 5, dadurch gekennzeichnet, das das Element (4) ein elektrisch gut leitendes Material (20, 24) umfaßt, das die äußere Oberfläche der aus der mechanischen Struktur (14) und dem Röntgenschutzmaterial (16) gebildeten Gesamtheit (14-16) bedeckt.

7. Schutzgehäuse nach einem der Ansprüche 1 bis 5, dadurch gekennzeichnet, daß das Element (4) eine Haube ist und ein elektrisch gut leitendes Material (22) umfaßt, das die innere Oberfläche der mechanischen Struktur bedeckt.

8. Schutzgehäuse nach Anspruch 6 oder 7, dadurch gekennzeichnet, daß das elektrisch leitfähige Material (20, 24, 22) unter der Nickei, dem Silber, dem Aluminium, dem Beryllium und dem Kupfer ausgewählt wird.

9. Schutzgehäuse nach einem der Ansprüche 1 bis 8, dadurch gekennzeichnet, daß die mechanische Struktur (14) an ihrer mit dem Röngenschutzmaterial (16) bedeckten Oberfläche Ein kerbungen (18) aufweist, die dazu dienen, die Haftung des Schutzmaterials auf der mechanischen Struktur zu verbessern.

10. Schutzgehäuse nach einem der Ansprüche 1 bis 9, dadurch gekennzeichnet, daß das zusammengesetzte Material, das die mechanische Struktur (14) bildet, ein wärmehärtbares Harz ist.

11. Schutzgehäuse nach einem der Ansprüche 1 bis 10, dadurch gekennzeichnet, daß die mechanische Struktur (14) durch Formgießen und das Röntgenschutzmaterial (16) durch übergießen der mechanischen Struktur erhalten wird.

## Claims

1. Protective box for electronic circuits hardened with respect to X-rays, characterized in that it comprises at least one element (4, 2) formed from a rigid mechanical structure (14) made from a composite material, constituted by a fibre-reinforced resin, and an X-ray protection material (16) at least partly (15, 17) covering the mechanical structure (14) and which (16) is formed from a resin matrix containing, in the form of a regularly dispersed powder, at least one metal and/or at least one inorganic compound of a metal, the powder only melting at a temperature at least equalto 630°C and the metal having a high atomic number at least equal to 47.

2. Protective box according to claim 1, characterized in that the powder represents 25 to 50% by volume of the X-ray protection material (16).

3. Protective box according to claims 1 or 2, characterized in that the high atomic number metal is chosen from among silver, tantalum, tungsten and uranium.

4. Protective box according to any one of the claims 1 to 3, characterized in that the element (4) comprises a material formed from at least one element with a low atomic number at the most equal to 6 and at least partly forming the outer or inner surface of the element (4).

5. Protective box according to claim 4, characterized in that the low atomic number element is chosen from among carbon, boron and beryllium.

6. Protective box according to any one of the claims 1 to 5, characterized in that the element (4) comprises a good electricity conducting material (20, 24) covering the outer surface of the assembly (14-16) formed by the mechanical structure (14) and the X-ray protection material (16).

7. Protective box according to any one of the claims 1 to 5, characterized in that the element (4) is a cover and comprises a material (22) which is a good electricity conductor covering the inner surface of the mechanical structure (14).

8. Protective box according to claims 6 or 7, characterized in that the electricity conducting material (20, 22, 24) is chosen from among silver, aluminium, beryllium and copper.

9. Protective box according to any one of the claims 1 to 8, characterized in that the mechanical structure (14) is provided on its surface covered with the X-ray protection material (16) with slots (18) for improving the adhesion of said material to the mechanical structure.

10. Protective box according to any one of the claims 1 to 9, characterized in that the material constituting the mechanical structure (14) is formed from a thermosetting resin.

11. Protective box according to any one of the claims 1 to 10, characterized in that the mechanical structure (14) is obtained by moulding and the X-ray protection material (16) by potting the mechanical structure (14).

FIG. 1

FIG. 2

FIG. 3